Europäisches Patentamt

European Patent Office

Office européen des brevets

(11) Publication number: **0 427 923 A2**

# EUROPEAN PATENT APPLICATION

(21) Application number: **90115155.5**

(51) Int. Cl.5: **G03F 7/16**

(22) Date of filing: **07.08.90**

(30) Priority: **13.11.89 US 435175**

(43) Date of publication of application:
**22.05.91 Bulletin 91/21**

(84) Designated Contracting States:
**DE FR GB IT NL SE**

(71) Applicant: **SHIPLEY COMPANY INC.**
**2300 Washington Street**
**Newton, Massachusetts 02162(US)**

(72) Inventor: **Ho, Ivan**
**57 Blanchett Drive**
**Marlboro MA(US)**
Inventor: **Harris, Martin J.**
**19 Dewey Street**
**Leominster MA 01453(US)**
Inventor: **Harrison, Richard**
**26 Dartmouth Drive**
**Milford MA 01757(US)**
Inventor: **Miller, Phillip J. Jr**
**68 Walnut Street**
**Belmont MA 02178(US)**

(74) Representative: **Leiser, Gottfried, Dipl.-Ing. et al**
**Patentanwälte Prinz, Leiser, Bunke & Partner**
**Manzingerweg 7**
**W-8000 München 60(DE)**

(54) Method for the reduction of pinholes in resist films.

(57) A process for applying a pinhole free organic coating on a conductive substrate during an electrodeposition process. The elimination of pinhole defects is accomplished by use of a vibrating device interfaced with the equipment which dislodges gas bubbles adhering to the surface of the substrate during the electrodeposition process.

FIG. I

# METHOD FOR THE REDUCTION OF PINHOLES IN RESIST FILMS

## BACKGROUND OF THE INVENTION

### 1. Introduction

This invention relates to a method for achieving a pinhole free organic coating applied to a conductive substrate during an electrodeposition process. In its preferred embodiment, the invention relates to uniformly depositing a photoresist onto a conductive substrate in a process for fabrication of printed circuit boards where an applied force is used on the substrate during deposition.

### 2. Discussion of Prior Art

Conventionally, images are produced on substrates by coating the substrate with a positive or negative photoresist material. It has been found that if the photoresist material is applied by electrodeposition, its adherence to the substrate improves.

The application of a photosensitive layer by electrodeposition is not novel as indicated in the prior art including the following: U.S. Patent No. 4,632,900, Japanese Patent Application No. 77-11601, and U.S. Patent No. 4,592,816 incorporated herein by reference. Substrates upon which the photoresist may be electrodeposited must be capable of accepting an electrical charge and are preferably either a solid metal sheet or a metal-faced laminate. In forming printed circuits on both sides of metal-faced laminates connected by thru-holes, it is necessary to protect exposed metal, including thru-holes, from subsequent processes. This is usually accomplished by coating the laminates with a photoresist film. The photosensitive resin composition of the film may be of either anionic or cationic nature as long as it gives a continuous film on the conductive coating of the substrate by electrodeposition. The preferred method is the use of a cationic resin system, where the substrate to be coated acts as the cathode and the anode is placed in the electrodeposition bath. The method can easily be applied to an anionic resin system, where the substrate acts as the anode and the cathode is placed in the electrodeposition bath.

In order to produce a sharp, well defined image, as is necessary in the manufacture of high density printed circuit boards or other photoimaged metals, it is essential that the film be continuous. The drawback to this is that in forming such continuous films, it is inevitable that faults, particularly pinholes, occur. The source of these pinhole defects stems from the presence of electrolysis gases generated in the coating bath during the electrodeposition process at she electrode and from hydraulic activity in the plumbing system of the bath. The occurence of these pinholes increases with time and with the number of substrates processed, due to the accumulation of electrolysis gases which lack buoyancy to rise to the top of the emulsion solution and dissipate. Instead, they cling to the substrate and prevent film coating in the bubble areas. These pinholes are a major cause of line reductions and open circuits in the innerlayers during manufacture of multilayer printed circuit boards. Other problems attributed to pinhole defects include etching of the metal in the area of the defect or plating in areas where these defects occur. Although factors influencing electrocoating such as voltage, amperage, temperature, and conductivity can affect the quantity of pinholes observed, this approach to limiting pinhole occurance could both limit the range of thicknesses coated, influencing overall yield, and affect coating time, uniformity, and appearance.

Several approaches to the problem of improved film adherence and performance are described in the prior art. Japanese patent Application No. 56-156745, describes a method for treating iron surfaces where an ultrasonic vibrating plate is immersed in a molten plating alloy solution to achieve an alloy coating on the surface of the iron plate. The ultrasonic waves strike the plate perpendicularly and create a large radiation pressure which in the presence of magnesium, destroys and disperses any oxidation film on the surface of the metal. The use of ultrasonic waves in electroplating is mentioned as a method of increasing the current density to a value several times the ordinary current density used. The invention disclosed herein differs from the above patent in that the current density is not affected. Changing the current density in an electrodeposition process would have a negative effect on coating uniformity, deposition rate, and consequently coating quality.

Another Japanese patent, Application No. 51-149833, describes a plating method in which a vibration is applied which causes a variation in the equipotential line between anodes and cathodes. In the preferred method, an electric current is caused to flow between the anodes and cathodes while the anodes are

2

caused to vibrate up and down, back and forth or left and right, or a composite of these motions. The change in equipotential between the cathode and anode creates a variation in the electrodeposition conditions of the plating layer. The invention disclosed herein differs from the above described patent in that there is minimal motion of the electrodes and the vibration is applied directly to the substrate to be coated. Also, it is not based on change in the electrical potential between the anode and cathode. Again, such changes in the equipotential would affect the current density and produce such negative effects on the coating as those described above.

The current invention also differs from the above inventions because electrodeposition processes are usually done at higher voltages than electroplating. Electroplating voltages are normally in the range of 6-24 volts, whereas in electrodeposition, the voltages can range up to 400 volts. The significance of this is that at the higher voltages, electrolysis of water occurs to a much greater extent and the problems associated with removal of gases from the surface of the substrate are more complex. The length of time for plating is significantly longer than for electrodeposition. This provides ample opportunities for removal of gases from the surface of the substrate by various means including current pulsing and reverse plating. In an electrodeposition process, the substrate is coated in a manner such that the time in the bath is on the order of 10 seconds.

Use of such ultrasonic transducers as described in the prior art inventions would also not be transferable to an electrocoating composition. Ultrasonic vibrations would drastically effect the stability of the coating emulsion.

The present invention discloses a method of achieving removal of gas bubbles from the surface of the substrate which would otherwise collect and destroy adhesion of the electrophoretic coating to the substrate. This is accomplished without changing other parameters that would adversely affect the coating performance.

## SUMMARY OF THE INVENTION

The disclosed invention relates to a method of achieving a pinhole free photoresist coating on a conductive substrate where the coating is applied during an electrodeposition process. The method of eliminating the pinhole defects is accomplished by use of vibrating devices which are easily interfaced with existing equipment and which do not place limitations on the coating process. The devices which may be used to practice the invention are capable of generating vibrations in magnitude from 60 vibrations per minute to over 30,000 vibrations per minute. The device is mounted to the electrodeposition apparatus in such a way that the vibrations are directed to the substrate to be coated.

## DESCRIPTION OF THE PREFERRED EMBODIMENTS

In the practice of the present invention, there is provided a method of achieving a pinhole free photoresist coating on a conductive substrate. The substrate may be a copper laminated substrate prepared by the method described in the second chapter of "Printed Circuits Handbook" by Clyde F. Coombs, Jr., 2nd Edition, McGraw-Hill, 1979. Other suitable substrates include those prepared by laminating multilayer boards for the manufacture of printed circuit boards with through-holes as described in chapter twenty three of the above reference, both incorporated herein by reference. Other suitable substrates include flexible metal foils, metal sheets or any other conductive substrates. The substrate may be flat or in various shapes and may be of varied thicknesses.

The photoresist coating used in the present invention may be of either anionic or cationic nature, so long as it can form a continuous film on the substrate by an electrodeposition means and can be dissolved by a developer during subsequent processes.

For example, such an electrodeposition bath of an anionic photosensitive resin composition may be prepared by copolymerizing an acidic group bearing $\alpha,\beta$-ethylenically unsaturated compound with a copolymerizable monomer having hydroxyl groups, adding to said hydroxyl groups of the thus obtained polymer a quinone diazide compound through an esterification reaction, neutralizing the acidic groups derived from said $\alpha,\beta$-ethylenically unsaturated compound with an alkaline substance, and dispersing the thus obtained neutralized polymer into water.

An electrodeposition bath of a cationic resin composition may be prepared by copolymerizing monomer having at least one amino group, adding to a part of said amino groups of the obtained copolymer a photoinitiator, neutralizing the remaining amino groups of said copolymer with an acidic substance, and

EP 0 427 923 A2

dispersing the thus obtained neutralized polymer into water.

The above general descriptions of the electrodeposition bath are given as examples and should not be taken as limitations as to the composition of such baths.

Other coating compositions capable of being used for the practiced process include those described in U.S. Patent No. 4,592,816 and U.S. Patent No. 4,632,900 incorporated herein by reference.

The present electrodeposition baths may include other additives as coloring matter and the like customarily used in an electrodeposition bath, as desired.

An example of a typical electrophoretic bath composition is shown below in Table I, where the relative concentration is expressed on a weight basis based on 100 parts by weight of the polymer.

TABLE 1

| Ingredient | Relative Concentration |
|---|---|
| Polymer | 100 |
| Solvent | 0-70 |
| Unsaturated Monomer | 30-50 |
| Photoinitiator | 3-8 |
| Acid | 1-3 |
| Water | 900-2600 |

In order to apply said anionic or cationic photosensitive resin composition on copper metal plated board, copper laminated substrate or any conductive substrate, a common electrophoretic means can be utilized in the present invention.

For example, when the substrate is dipped in an electrodeposition bath of the anionic photosensitive resin composition, an anode is connected to the substrate and a cathode is placed in the bath, direct current is flowed between the electrodes, thereby depositing the anionic photosensitive resin composition to the substrate.

In the case of using a cationic resin composition bath, the anode and the cathode are connected inversely and the similar procedure is carried out to obtain a continuous film of the cationic photosensitive resin composition.

The practiced improvement which produces the pinhole free coating in the above described processes involves interfacing a device to the outside of the electrodeposition tank in such a way as to produce vibrations of sufficient frequency and amplitude to displace bubbles generated at the surface of the substrate during the deposition of the coating. The vibrations may be generated in a reciprocating or rotary manner.

For example, if a vibration motor is used, it may be an electric type motor or pneumatic turbine type motor. The motor should be capable of being attached in any position, watertight and have adjustable speeds. An electric type motor should be able to generate speed between 1,600 and 3,200 vibrations per minute. The pneumatic turbine type motor should generate speeds between 12,000 and 15,000 vibrations per minute at an air flow of 60 psi. The vibration range necessary to practice the invention is 60 - 30,000 vibrations per minute. The preferred vibration is 3,000 vibrations per minute or higher. Other devices may be used to produce the necessary vibrations and the examples described herein should not be taken as limitations to the practice of the invention.

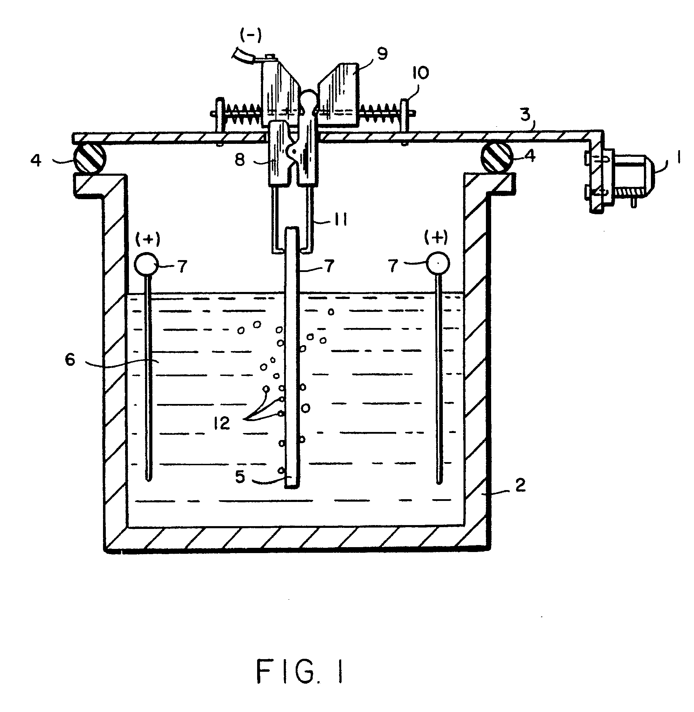

The device to be used is mounted in such a way that the vibrations are isolated and transferred directly to the substrate. Figure 1 shows an example of how the invention may be practiced. For example, a motor-(1) may be mounted to the outside of the tank(2) by means of an attached yoke (3) placed over the tank. Positioning of the motor is such that it is equidistant from both ends of the tank. The yoke is separated from the tank by use of rubber cushions(4) capable of absorbing the vibrations, thereby isolating the vibrations from the tank and directing them only to the substrate (5). The electrodeposition tank contains the electrophoretic coating bath(6) and electrodes(7), the substrate serving as an electrode of opposite charge. The substrate is placed in the bath by attaching it to a flight bar (8) which is held in place by two spring loaded clamps(9) attached to the yoke by means of a flange(10). The flight bar is constructed such that the substrate is held in a position by clips(11) which insures electrical conductivity and transfer of the vibrations directly to the substrate so that bubbles(12) generated by electrolysis of water during electrodeposition are removed.

4

Again, the above description is only one example of a device that may be used to practice the invention. Other examples of devices capable of producing the necessary vibrations include an orbital sander, an impact hammer, a vibrating engraver, or a hammer. It is necessary to attach the device in such a way that the vibrations are directed to the flight bar for transfer directly to the substrate. The device may be bolted to the flight bar, clamped or attached in any way which directs the vibrations to the flight bar. Other means of directing the vibration only to the flight bar would include attaching to any overhead support such that the vibrating device is in continuous contact with the flight bar.

The following table illustrates the reduction in pinhole defects attributed to the practice of the invention:

TABLE 2

| Substrate: Copper Laminated Board | |
| --- | --- |
| Bath: Electrodeposition Photoresist Formulation (Such as shown in Table 1) | |
| Voltage: 75 volts | |
| Temperature: 35°C | |
| Dwell Time: 30 seconds | |
| Device | Avg. Number of Pinholes per 310 cm$^2$ panel |
| Control | 303.5 |
| Manual Hammering (on the flight bar 1 hit/sec) | 42.0 |
| Vibrating Engraver (placed against flight bar) | 34.5 |
| Impact Hammer (directed to the flight bar) | 17.3 |
| Orbital Sander (held against the flight bar) | 14.0 |
| Vibration Motor (attached to yoke) | < 3.0 |

After depositing the continuous photosensitive film to the substrate using the above invention, the coating is then subjected to conventional steps used in the manufacture of printed circuit boards. The film is exposed, through a mask bearing the circuit pattern, to actinic radiation such as that from an arc lamp. In the case of a positive working resist, whether anionic or cationic, the exposed area is rendered soluble and may be removed by an acidic or alkaline developer, respectively. With a negative working resist, whether anionic or cationic, the unexposed material is made soluble and is removed in the developer. In either case, the residual resist adheres to the board during subsequent etching steps in which cupric or ferric chloride or an ammoniacal solution dissolves the exposed copper. The imaged resist may then be removed after the etching step with an organic or aqueous stripping solution.

The same technology applies when the electrodeposited resist is used as a plating resist, i.e. the resist is applied over a pre-existing conductive film. After imaging, metal is plated into the lines formed after development of the resist, with side walls determining the profile of the added metal. The resist may then be stripped as described above.

## Claims

1. A method of eliminating pinhole defects formed during an electrodeposition process which comprises the steps of depositing an organic coating material onto a conductive substrate and applying a continuous vibrational force of sufficient energy to said substrate so as to displace gas bubbles adhering to said substrate.

2. The method of claim 1 wherein said organic coating material is anionic.

3. The method of claim 1 wherein said organic coating material is cationic.

4. The method of claim 1 wherein said conductive substrate is a copper laminated substrate.

5. The method of claim 1 wherein said conductive substrate is a flexible metal foil.

6. The method of claim 1 wherein said conductive substrate is a solid metal sheet.

7. The method of claim 1 wherein said vibrational force is produced by a pneumatic motor.

8. The method of claim 1 wherein said vibrational force is produced by an electric motor.

9. The method of claim 1 wherein said force of sufficient energy is in the range of 60 - 30,000 vibrations per minute.

10. The method of claim 1 wherein said frequency and amplitude of said force of sufficient energy is 3,000 vibrations per minute.

11. An improved process for making printed circuit boards comprising the steps of:

a. providing a conductive substrate with an electrophoretically deposited photosensitive coating

b. image-wise exposing the thus deposited coating to a source of actinic radiation and treating said exposed photoresist with a suitable developing solution

c. subjecting said photoresist to an etching procedure prior to removal of the resist material said improvement comprising depositing said photosensitive coating as a pinhole free continuous film by applying a continuous vibrational force of sufficient energy to said substrate whereby gas bubbles generated during said electrophoretic deposition are displaced.

12. An apparatus for the electrodeposition of an organic coating onto a substrate which comprises:

a. a bath of organic coating material

b. a tank for containing said bath

c. a conductive substrate to be immersed in said bath

d. a source of electrical potential connected to said substrate

e. an electrode in contact with said coating bath and connected to the opposing pole of said source, and

f. a means of selectively applying sufficient vibrational force to said substrate to displace bubbles adhering to the substrate.

13. The apparatus of claim 12 wherein said means of selectively applying said vibrational force further comprises:

a. a flight bar connected to said substrate

b. clamps which hold said flight bar

c. a yoke on which said clamps are attached and which is simultaneously in contact with a vibrational source and

d. cushions between said tank and said yoke whereby the tank is not vibrated.

14. The apparatus of claim 13 wherein said vibrational source is an electric motor.

15. The apparatus of claim 13 wherein said vibrational source is a pneumatic motor.

16. The apparatus of claim 12 wherein the surface of said conductive substrate is metallic.

17. The apparatus of claim 12 wherein said conductive substrate is a copper laminated substrate.

18. The apparatus of claim 12 wherein said organic coating is anionic.

19. The apparatus of claim 12 wherein said organic coating is cationic.

20. The apparatus of claim 12 wherein said organic coating is photosensitive.

21. An article of manufacture produced by the method of claim 1.

FIG. I